# EUROPÄISCHE PATENTSCHRIFT

(11) **EP 1 023 749 B1**
(45) Veröffentlichungstag und Bekanntmachung des Hinweises auf die Patenterteilung: **05.06.2002**
(21) Anmeldenummer: 98954288.1
(22) Anmeldetag: 28.09.1998
(51) Int. Cl.: H01S 5/024, H01S 5/068

(54) **HALBLEITERLASERCHIP**
SEMICONDUCTOR LASER CHIP
PUCE LASER A SEMICONDUCTEUR

(30) Priorität: 18.10.1997 DE 19746204
(43) Veröffentlichungstag der Anmeldung: 02.08.2000
(73) Patentinhaber: Deutsche Telekom AG, 53113 Bonn (DE)
(72) Erfinder: RICHTER, Hartwig, D-64291 Darmstadt (DE); BECKER, Manfred, D-10409 Berlin (DE)
(86) Internationale Anmeldenummer: EP9806144
(87) Internationale Veröffentlichungsnummer: WO9921251

(56) Entgegenhaltungen:
- DE-A- 19 546 443
- FR-A- 2 656 093
- US-A- 5 140 605
- PATENT ABSTRACTS OF JAPAN vol. 006, no. 251 (E-147), 10. Dezember 1982 & JP 57 149784 A (NIPPON DENKI KK), 16. September 1982
- PATENT ABSTRACTS OF JAPAN vol. 009, no. 131 (E-319), 6. Juni 1985 & JP 60 015987 A (HITACHI SEISAKUSHO KK), 26. Januar 1985
- PATENT ABSTRACTS OF JAPAN vol. 011, no. 095 (E-492), 25. März 1987 & JP 61 247083 A (NEC CORP), 4. November 1986
- PATENT ABSTRACTS OF JAPAN vol. 013, no. 232 (E-765), 29. Mai 1989 & JP 01 037893 A (NEC CORP), 8. Februar 1989
- PATENT ABSTRACTS OF JAPAN vol. 013, no. 581 (E-865), 21. Dezember 1989 & JP 01 245585 A (NEC CORP), 29. September 1989
- PATENT ABSTRACTS OF JAPAN vol. 013, no. 531 (E-851), 28. November 1989 & JP 01 216586 A (SEIKO EPSON CORP), 30. August 1989

## Beschreibung

Die Erfindung betrifft ein Halbleiterlaserchip nach dem Oberbegriff des Patentanspruchs 1.

Halbleiterlaser sind grundsätzlich bekannt, wie zum Beispiel aus der hinten angegebenen und diskutierten Veröffentlichung von Dr. Richter, TelekomVision 7/93, hervorgeht.

Der Einsatz eines solchen Lasers ist in der Veröffentlichung von K. H. Park u.a. "Fabrication and transmission experiments of distributed feedback laser modules for 2.5 Gb/s optical transmission systems" erschienen in Optical and Quantum Electronics 27 (1995), 547-552 ausführlich dargestellt. Zur weiteren Kapazitätssteigerung werden zunehmend optische Trägerfrequenztechniken, auch Wellenlängenmultiplexsysteme genannt, eingesetzt. Die Ausgangswellenlänge der in diesen Systemen eingesetzten Halbleiterlaser muß in einem sehr engen Bereich eingestellt und nachgeführt werden können. Als Stellgrößen hierzu dienen die von außen eingestellte Temperatur des Laserträgers und der Pumpstrom des Lasers.

Bei konstantem Pumpstrom führt eine fehlerhafte Bestimmung der Temperatur des Laserchips zu Abweichungen der Ausgangswellenlänge, insbesondere, wenn aus betrieblichen Gründen der Pumpstrom verändert werden muß. Solche Gründe können ungewollt, wie zum Beispiel Alterungseffekte des Lasers oder auch gewollt, wie zum Beispiel Änderungen der Ausgangsleistung des Lasers bei Änderung der Streckendämpfung oder nach einer Netzneukonfiguration in geschalteten Netzen (Routing, Leitungsersatzschaltung) sein.

Während bei Nachrichtenlasern Einwelligkeit und geringe Linienbreite sowie eine schnelle Modulierbarkeit im Vordergrund stehen, ist für Zwecke wie Materialbearbeitung eine hohe Ausgangsleistung des Halbleiterlasers wichtig. Diese Hochleistungslaser sind oft im Vergleich zu Nachrichtenlasern sehr lang (bis zu 2 Millimeter). Unvermeidliche Fertigungsinhomogenitäten entlang der laseraktiven Zone führen zu lokalen Temperaturspitzen, besonders im Betrieb mit höchsten Ausgangsleistungen. Diese inhomogene Temperaturverteilung führt zu einer Abnahme der Ausgangsleistung und im Extremfall zur irreversiblen Degradation des Lasers.

Die Temperatur eines Lasers wird bisher nur an einer Stelle gemessen, nämlich an seinem als Wärmesenke dienenden Laserträger. Fehler bei der Temperaturmessung können entstehen durch den Wärmeübergangswiderstand zwischen Laserchip und Wärmesenke sowie durch die endliche Wärmeleitfähigkeit des Laserchipmaterials, hinzu kommen weitere Wärmequellen durch Bahnwiderstände im Pfad des Pumpstromes. Neben diesen stationären Meßfehlern der Temperatur ergeben sich auch große Zeitkonstanten, die eine Temperaturregelung nachteilig beeinflussen. Bei Hochleistungslasern werden bisher Inhomogenitäten des Temperaturverlaufs überhaupt nicht erfaßt. In der DE 19 546 443 und in der EP 0 779 526 ist eine optische und/oder elektrooptische Verbindung und ein Verfahren zur Herstellung einer solchen für zwei optische und/oder elektrooptische Komponenten bekanntgeworden. Insbesondere in Fig. 7 dieser Schrift ist die Befestigung eines Pumpstromzuführungsdrahtes in einem Halbleiterlaser gezeigt und in der zugehörigen Beschreibung offenbart. Außerdem ist beschrieben, wie ein Loch mit Laserschweißlicht in ein Laserchip gebohrt werden kann.

Weitere Laserchips bzw. Halbleiterlasermodule sind grundsätzlich in der DE 42 32 326 und in der DE 42 32 327 beschrieben.

Wie bereits ausgeführt wurde, wird üblicherweise die Temperatur eines Lasers nur an einer Stelle gemessen, nämlich an seinem als Wärmesenke dienenden Laserträger.

In Patent Abstracts of Japan, vol. 006, no. 251 (E-147), 10. Dezember 1982 & JP 57 149784 A ist prinzipiell ein Halbleiterlaser mit einer Anordnung zur Messung der Betriebstemperatur beschrieben, wobei der Temperaturfühler am Rahmen und Schutzgehäuse montiert ist. Es wird hier also eine hybride Integration von getrennt hergestellten Teilen zu einem neuen Teil beschrieben. Der Vorteil dieser Anordnung gegenüber dem damaligen Stand der Technik besteht darin, daß ein Temperaturdetektor und ein Kühler zusätzlich in das Laserdiodengehäuse eingebaut werden. Damit konnte eine Verkleinerung erreicht werden und auch die Wellenlängenschwankungen konnten verringert werden.

In Patent Abstracts of Japan, vol. 009, no. 131 (E-319), 6. Juni 1985 & JP 60 015987 A ist beschrieben, daß ein Temperaturfühler direkt in den Halbleiterchip integriert wird. Dazu ist ein zusätzlicher pn-Übergang erforderlich. In einem zusätzlichen Herstellungsschritt wird Dotierungsmaterial in den Halbleiterlaserchip eindifundiert und anschließend wird diese Zone mit einem ohmschen Kontakt versehen. Die Temperatur wird über Spannungsrichtungswechsel abgebildet.

Der Erfindung liegt die Aufgabe zugrunde, eine Anordnung eines Temperaturfühlers oder mehrerer Temperaturfühler, die eine genauere und/oder lokal aufgelöste Messung der Betriebstemperatur ermöglicht bzw. ermöglichen, zu schaffen, wobei auch ein Temperaturfeinabgleich mit hoher Temperatureinstellungsgenauigkeit und/oder -ortsselektivität realisierbar sein soll.

Die erfindungsgemäße Lösung ist im Kennzeichen des Patentanspruchs 1 charakterisiert.

Weitere Ausgestaltungen der Erfindung bzw. Lösungsmerkmale sind in den Patentansprüchen 2 bis 13 charakterisiert.

Dadurch, daß ein oder mehrere Temperaturfühler mittels Schweißens mit Nd-YAG-Laserlicht oder Licht mit ähnlichen Eigenschaften direkt auf dem Laserchip und in inniger Verbindung mit demselben befestigt wird oder werden, wird eine sehr hohe Genauigkeit erreicht, die bisher nicht möglich war. Der Temperaturfeinabgleich wird vorteilhafterweise mittels Peltierelementen durchgeführt, wobei die Komponenten der Peltierelemente mittels Nd-YAG-Laserlicht-Schweißens direkt auf dem Laserchip aufgebracht werden. Erfindungsgemäß wird die Wellenlänge des Laserchips gemessen und wenn es erforderlich ist, wird die Wellenlänge des Laserchips auch eingestellt, wobei die Nachrichtenlaser einen Meßpunkt pro laseraktiver Zone und die Hochleistungslaser mehrere Meßpunkte pro Laserchip entlang der laseraktiven Zone aufweisen.

Weitere Vorteile, Merkmale und Anwendungsmöglichkeiten der vorliegenden Erfindung ergeben sich aus den Unteransprüchen sowie aus der nachfolgenden Beschreibung in Verbindung mit den Zeichnungen. In der Beschreibung, in den Patentansprüchen, in der Zusammenfassung und in den Figuren werden die in der hinten anhängenden Liste der Bezugszeichen verwendeten Begriffe und Bezugszeichen verwendet.

Die Erfindung wird nun anhand von Ausführungsbeispielen näher erklärt. In der Zeichnung bedeuten:
- Fig. 1: einen Halbleiterlaserchip nach dem Stand der Technik;
- Fig. 2: eine Anordnung und Aufbringung eines bekannten Fühlers auf dem Laserchip;
- Fig. 3: einen in Glas eingekapselten Fühler;
- Fig. 4: ein Halbleiterlaserchip mit gebohrtem Loch mittels Laserschweißlicht;
- Fig. 5a: eine Anordnung mit Bahnwiderstand als Fühler;
- Fig. 5b: eine Anordnung mit symmetrischem Fühler;
- Fig. 6: eine Darstellung des Bahnwiderstandes parallel zum Pumpstrompfad;
- Fig. 7: eine Anordnung zur Messung der Temperatur von Einzellasern mit Bahnwiderstandsfühlern;
- Fig. 8: eine Anordnung zur Messung der Temperaturinhomogenität mit Bahnwiderstandsfühlern;
- Fig. 9: ein auf einem Laserchip aufgebrachtes Thermoelement;
- Fig. 10: ein Thermoelement mit nur einem zusätzlichen Draht,
- Fig. 11: eine Anordnung zur Temperaturregelung mit Thermo- und Peltierelement,
- Fig. 12: eine Anordnung kaskadierter Thermoelemente auf einem Laserchip und
- Fig. 13: eine Anordnung zur ortsselektiven Temperaturregelung.

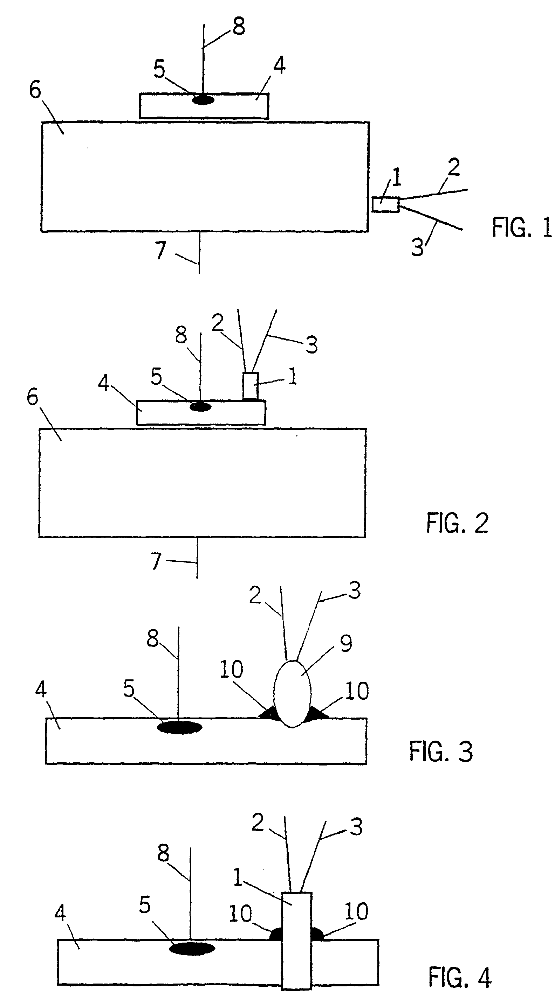

Die Fig. 1 zeigt den Aufbau eines bekannten Laserchips wie er zum Beispiel in dem Aufsatz "Chips mit Zukunftspotential", Zwischenbilanz des Telekom Forschungsprojektes OEIC von Dr. Hartwig Richter in TelekomVision 7/93, Seiten 41 bis 47 beschrieben ist. Die Temperatur eines Lasers wurde bisher nur an einer Stelle, nämlich an seinem als Wärmesenke dienenden Laserträger gemessen. Dabei ist an der Wärmesenke 6 ein Temperaturfühler 1 mit seinen Zuführungsdrähten 2 und 3 angebracht. Der Halbleiterlaserchip 4, auch kurz Laserchip genannt, mit seiner laseraktiven Zone 5 erhält seinen Pumpstrom über die Drähte 7 und 8 für die Zuführung des Pumpstromes. Wie bereits weiter vorne beschrieben, hat eine derartige Anordnung folgende Nachteile: Die Differenz zwischen der Temperatur des Halbleiterlaserchips 4, die für die Ausgangswellenlänge des Lasers bestimmend ist, und der von außen eingestellten Temperatur der Wärmesenke 6, wird nicht erfaßt. Die Ursachen für die Temperaturdifferenz sind die Wärmeübergangswiderstände zwischen Laserchip 4 und -träger bzw. Wärmesenke 6 sowie die endliche Wärmeleitfähigkeit des Laserchipmaterials. Außerdem kommen weitere Wärmequellen durch Bahnwiderstände im Pumpstrompfad hinzu. Daraus ergeben sich neben den stationären Meßfehlern der Temperatur auch noch große Zeitkonstanten, die eine Temperaturregelung nachteilig beeinflussen.

In Fig. 2 ist dargestellt, wie ein schon bekannter Temperaturfühler 1 mittels Schweißens mit Laserlicht auf dem Laserchip 4 aufgebracht werden kann. Der übrige Aufbau der Anordnung nach Fig. 2 entspricht dem der Fig. 1. Die bei dieser Schweißmethode gebildeten Schmelzpunkte 10 befestigen den Temperaturfühler 1 auf dem Laserchip 4, wie in Fig. 3 dargestellt. Nach den jeweiligen Erfordernissen kann es nötig und/oder auch vorteilhaft sein, den Temperaturfühler 1 vor dem Aufbringen auf dem Laserchip 4 in ein wärmeleitendes, gut schweißbares Material 9, zum Beispiel Glas, einzukapseln, wie in Fig. 3 gezeigt ist. Der übrige Aufbau entspricht wieder dem bereits vorher beschriebenen, jedoch ist die Wärmesenke 6 des Halbleiterlasers 4 nicht dargestellt, da hier lediglich die Anordnung eines eingekapselten Temperaturfühlers 1 gezeigt werden soll.

In Fig. 4 ist ein solcher Temperaturfühler 1 in einem vorgebohrtem Loch zu sehen, hier ist wieder der Laserchip 4 mit dem Draht 8 für die Pumpstromzuführung sowie die Drähte 2 und 3 für die Meßstromzuführung an den Temperaturfühler 1 dargestellt. Außerdem sind die Drähte 2 und 3 zur Meßstromzuführung an den Temperaturfühler 1 dargestellt.

Zur Erzeugung des Loches für den Temperaturfühler 1 im Laserchip 4 kann ebenfalls Laserlichtstrahlung verwendet werden, wie es in der DE 19 546 443 beschrieben ist.

Es soll hier bemerkt werden, daß die beschriebene Art und Weise der Anordnung eines oder mehrerer Temperaturfühler sowie der Temperaturfeinabgleich mit hoher Temperatureinstellungsgenauigkeit und/oder Temperaturortsselektivität auch für Laserchips aus thermisch isotropen Material ohne weiteres anwendbar sind.

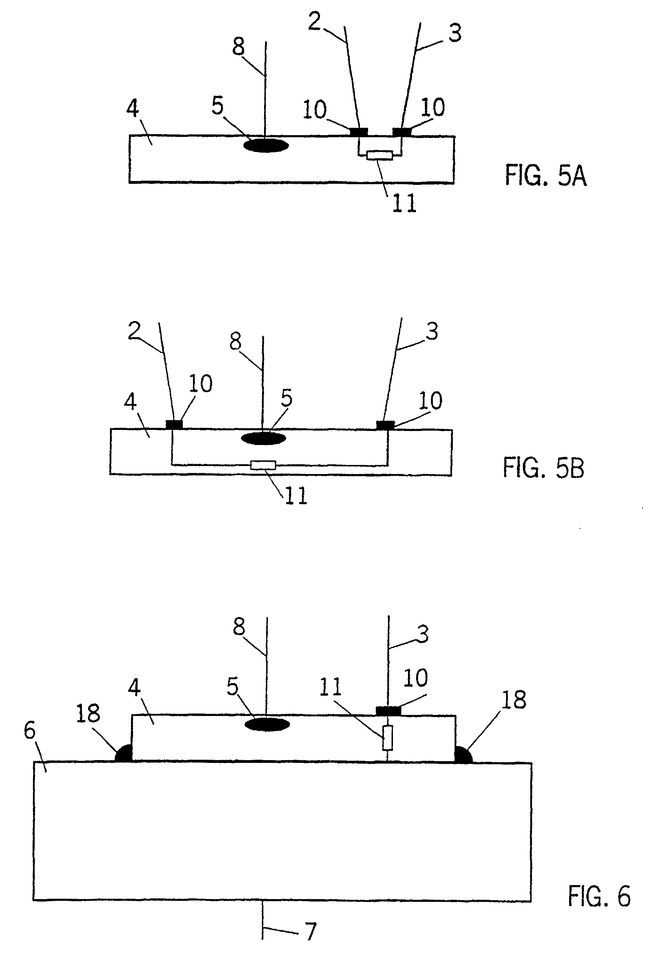

Durch die Anordnungen gemäß der Figuren 5a, 5b und 6 ist es möglich, die Temperaturabhängigkeit des Bahnwiderstands 11 selbst zu messen. Der Widerstand ergibt sich zwischen den beiden Schmelzpunkten 10, an denen die beiden Drähte 2 und 3 für die Meßstromzuführung mittels Schweißens oder nach einem anderen Verfahren, zum Beispiel Bonden angebracht sind. Außerdem sind die Zuführungsdrähte 2 und 3 für den Meßstrom und der Zuführungsdraht 8 für den Pumpstrom dargestellt.

In Fig. 5b ist eine Anordnung mit symmetrischem Fühler gezeigt, wobei der Einzellaser 5 symmetrisch zwischen den Schmelzpunkten 10 im Laserchip 4 angeordnet ist. Der Bahnwiderstand 11 liegt hier wieder zwischen den beiden Meßpunkten 10.

In Fig. 6 ist dargestellt, daß der Bahnwiderstand 11 parallel zum Pumpstrompfad angeordnet ist, wobei hier wieder die Wärmesenke 6 mit dem Laserchip 4 mittels beim Schweißen gebildeter Schmelzpunkte 18 verbunden ist. Die Wärmesenke 6 ist mit einem Draht 7 zur Zuführung des Pumpstromes verbunden und der Einzellaser 5 ist ebenfalls mit einem Draht 8 zur Zuführung des Pumpstromes verbunden. Der Draht 3 ist mit dem Schmelzpunkt 10 verbunden, um den erforderlichen Meßstrom zuführen zu können.

Der zweite Schmelzpunkt 10 für den Draht 2 entfällt hier, statt dessen kann der Draht 7 oder der Draht 8 mitbenutzt werden.

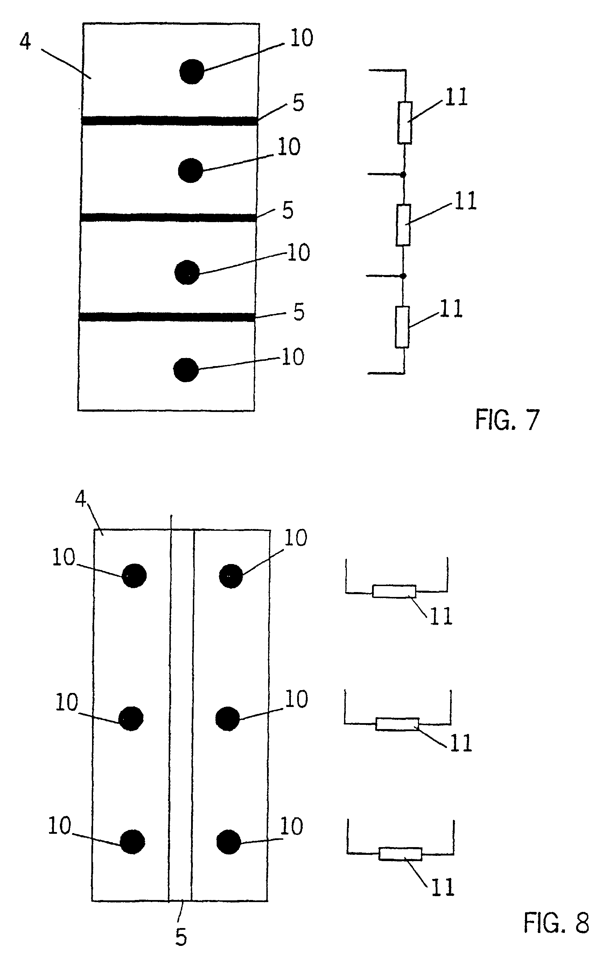

In Fig. 7 ist das Messen der Temperatur von Einzellasern 5 mit Bahnwiderstandsfühlern gezeigt. Die einzelnen Bahnwiderstände 11 liegen zwischen den Schmelzpunkten 10 der Einzellaser 5, die sich auf oder in einem Laserchip 4 befinden. Dadurch ist aufgezeigt worden, daß bei der Anordnung von mehreren Einzellasern 5 auf einem Laserchip 4 die Temperatur jedes Einzellasers 5 gemessen werden kann. Dadurch ist es während des Betriebes möglich, die Ausgangswellenlängen dieser Einzellaser 5 über deren Pumpströme einzustellen, ohne explizit ihre Wellenlänge zu messen.

Eine ähnliche Technik (Fig. 8) ermöglicht bei Hochleistungslasern die Messung der Temperaturverteilung entlang einer laseraktiven Zone eines Einzellasers 5 auf oder in dem Laserchip 4.

Besondere Vorteile ergeben sich, wenn der Temperaturfühler 1 ein Thermoelement ist. Dann kann nicht nur ein vorher gefertigtes Thermoelement mittels Laserlicht-Schweißens direkt auf dem Meßobjekt im engen thermischen Kontakt mit demselben befestigt werden wie bereits beschrieben, sondern es ist möglich, in einem Arbeitsschritt die beiden für das Thermoelement notwendigen Einzeldrähte mittels Laserlicht-Schweißens zu einem Thermoelement zu verbinden und auf dem Meßobjekt zu befestigen.

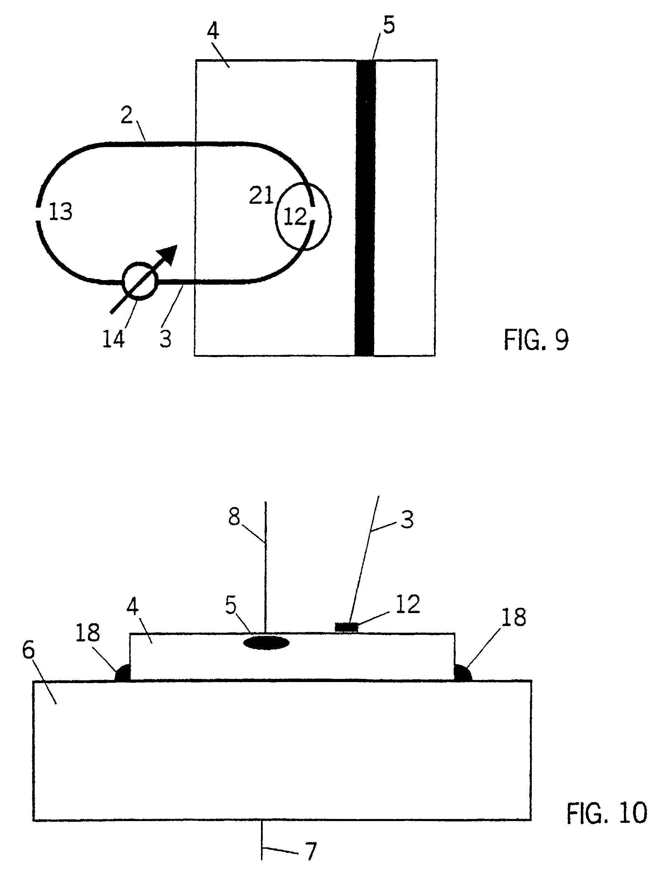

Wie aus der Anordnung eines Thermoelements auf einem Laserchip 4 aus Fig. 9 hervorgeht, hat jetzt jedes Thermoelement, hier gezeigt als Meßpunkt 12, je einen Meßzuführungsdraht 2 und einen Meßzuführungsdraht 3 aus unterschiedlichem Material.

Besonders vorteilhaft ist, vor dem Zusammenführen der Drähte 2 und 3 auf dem Laserchip 4 eine Kontaktfläche 21 auf dem Halbleiterlaser 4 aufzudampfen oder sonst geeignet anzubringen, wobei diese Fläche 21 entweder aus dem Material des Drahtes 2 oder dem Material des Drahtes 3 besteht (Fig. 9).

Die zweite Zusammenführung der Drähte 2 und 3 bildet ein zweites Thermoelement 13. Im Punkt 14 kann dann eine von der Temperaturdifferenz zwischen den Punkten 12 und 13 abhängige Spannung abgegriffen werden, dabei muß das Meßinstrument am Punkt 14 von Drähten gleichen Materials eingeschlossen sein. Selbstverständlich können die Drähte 2 und 3 auch teilweise oder vollständig als fest mit einem Chip (z.B. dem Laserchip 4) verbundene Leiterbahnen ausgeführt werden. Dabei kann der Temperatur-Referenzpunkt 13 auf dem Chip 4 selbst, auf der Wärmesenke 6 des Halbleiterlasers 4 oder sogar auf dem die Gesamtanordnung entsprechend Fig. 1 umgebenden Gehäuse sein.

In Fig. 10 ist eine Ausführung dargestellt, die mit nur einem zusätzlichen Draht 3 auskommt, in dem der sonst erforderliche Draht 2 der Pumpstromzuführungsdraht 8 ist, zum Beispiel in Gold oder Kupfer ausgeführt. Der andere Draht 3 für das Thermoelement 12 besteht zum Beispiel aus Konstantan.

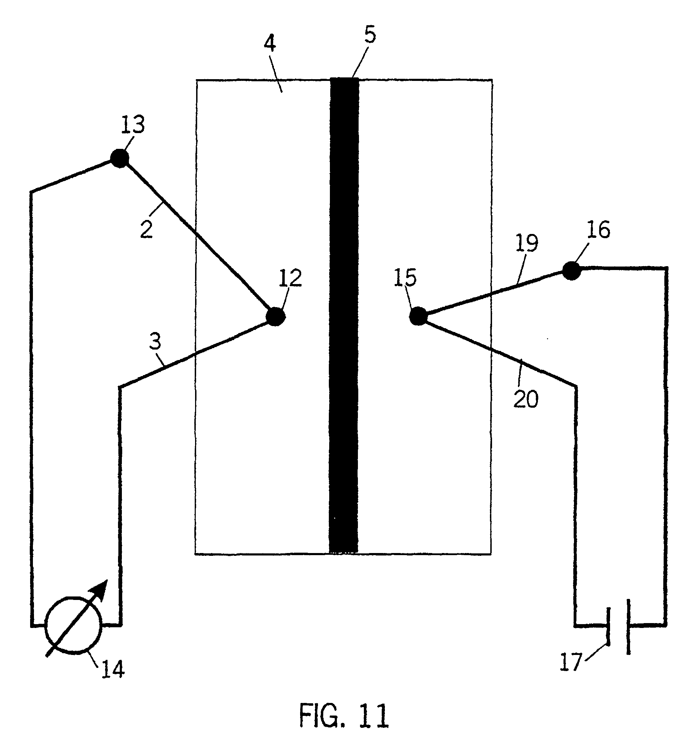

Ein weiterer Vorteil ergibt sich, wenn ein Thermoelement nach Fig. 11 umgekehrt als Peltierelement mit einer Stromquelle 17 eingesetzt wird. Ähnlich wie in der Meßanordnung nach Bild 9 bestehen auch hier die Drähte 19 und 20 zwischen den Punkten 15 und 16 aus verschiedenen Materialien. Je nach Richtung des Stromes der Quelle 17 kann dann Wärme vom Punkt 15 zum Punkt 16 (Hauptanwendungsfall: der Halbleiterlaser 4 wird entwärmt) oder vom Punkt 16 zum Punkt 15 (der Halbleiterlaser 4 wird zusätzlich aufgeheizt) transportiert werden.

Die Herstellung des aus den Drähten 19 und 20 zwischen den Punkten 15 und 16 gebildeten Peltierelementes erfolgt mit derselben Technologie wie das in Fig. 9 beschriebene Thermoelementpaar 2,3,12,13.

Mit einem als Temperaturfühler eingesetztem Thermoelementpaar entsprechen Fig. 9 und einem als Temperatursteller betriebenen Peltierelement 15, 16, 19,20 kann eine Feinregelung der Temperatur des Punktes 15 durchgeführt werden. Zur Verringerung von Regelfehlern sollte der Punkt 15 nah am Punkt 12 sein. Ein nicht gezeigter Regler steuert dann die Stromquelle 17 als Funktion der Meßspannung 14 des Thermoelementpaares 12 und 13, wobei der Meßpunkt 13 ein externer Referenzpunkt ist. Bei dieser Regelung ist es vorteilhaft, wenn der Referenzpunkt 13 und der Wärmereferenzpunkt 16 (im Hauptanwendungsfall Wärmesenke) des Peltierelementes die gleiche Temperatur haben. Dieser Bezugsort 13 bzw. 16 kann ein Punkt außerhalb des Lasergehäuses sein (Messung gegen Umgebungstemperatur). Es ist aber auch möglich, den Bezugsort auf der Wärmesenke 6 des Halbleiterlasers 4 anzubringen (Messung der Differenztemperatur zur Wärmesenke 6 des Halbleiterlasers 4, gegebenenfalls mit Entwärmung ebenfalls zur Wärmesenke 6 des Halbleiterlasers 4).

Ist der Halbleiterlaser 4 ein Nachrichtenlaser, kann so seine Ausgangswellenlänge sehr fein abgestimmt werden.

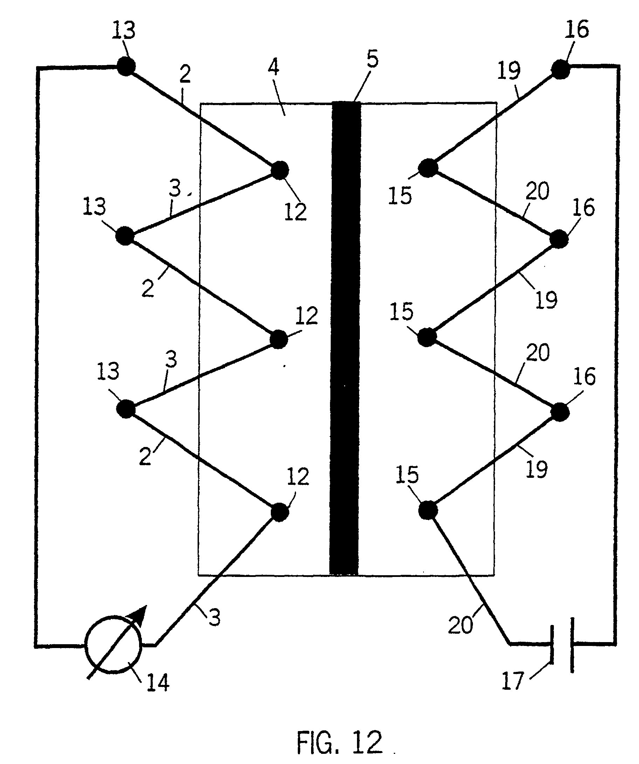

Für sehr lange Laser 4 (zum Beispiel Hochleistungslaser) ist es - wie in Fig. 12 dargestellt - auch möglich, sowohl die Thermoelementpaare 12 und 13 als auch die Peltierelemente 15 und 16 zu kaskadieren, um so eine homogenere Entwärmung zu erreichen.

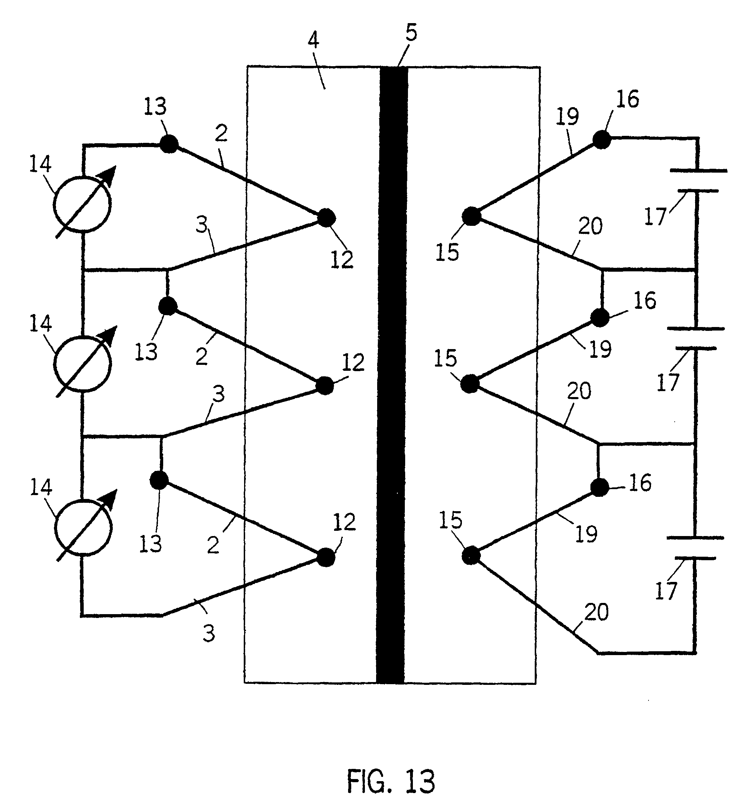

In Fig. 13 ist gezeigt, wie insbesondere bei Hochleistungslasern die ausgangsleistungsbegrenzenden Temperaturinhomogenitäten, insbesondere entlang der laseraktiven Zone 5, verringert werden können. Jede Meßspannung 14 des zugehörigen Meßpunktes 12 erzeugt in einem eigenen Regler einen eigenen Stellstrom 17 zur Entwärmung des zugehörigen Entwärmungspunktes 15. Die Dimensionierung der Regler ist besonders einfach, wenn alle Bezugspunkte 13 und alle Wärmereferenzpunkte 16 die gleiche Temperatur haben.

Mit dieser ortsselektiven Temperaturregelung ist es z. B. möglich, besonders heiße Punkte stärker zu entwärmen als weniger heiße und so einen gleichmäßigen Temperaturverlauf entlang der laseraktiven Zone 5 des Laserchips 4 zu erreichen.

Weitere Ausgestaltungen, bzw. Anordnungen, die sich je nach Erfordernis aus dem jeweiligen Laserchip und dessen Einsatzgebiet ergeben, sind ohne weiteres in der hier angegebenen Technik möglich.

### Liste der Bezugszeichen

- 1: Temperaturfühler
- 2,3: Drähte (zur Meßstromzuführung)
- 4: Laserchip oder Halbleiterlaserchip
- 5: Einzellaser
- 6: Wärmesenke bzw. Laserträger
- 7,8: Drähte (für Pumpstromzuführung)
- 9: schweißbares Material (Glas)
- 10: Meßpunkte oder Schmelzpunkte
- 11: Bahnwiderstände
- 12: Meßpunkt oder Thermoelement
- 13: Thermoelemente (Referenzpunkte)
- 14: Meßspannung
- 15,16: Peltierelement
- 17: Stromquelle (für Temperaturänderungsstrom)
- 18: Schmelzpunkte
- 19,20: Drähte (zur Stellstromzuführung)
- 21: Kontaktfläche

## Patentansprüche

1. Halbleiterlaser mit Temperaturfühler direkt auf dem Halbleiterlaserchip zur Messung der Betriebstemperatur angeordnet, **dadurch gekennzeichnet,**
**daß** mindestens ein Temperaturfühler (1) mittels Schweißens direkt auf dem bzw. im Halbleiterlaserchip (4) befestigt ist, wobei die zum Schweißen erforderliche Energie aus einer Lichtquelle, insbesondere einer Nd-Glas-Quelle oder einer NdYAG-Quelle oder einer Quelle mit ähnlicher räumlicher und ähnlicher spektraler Verteilung, erzeugbar ist.

2. Halbleiterlaser nach Patentanspruch 1, **dadurch gekennzeichnet,**
**daß** der Temperaturfühler (1) vor dem eigentlichen Schweißvorgang in ein elektrisch hochisolierendes Glas eingeschmolzen wird.

3. Halbleiterlaser nach einem der Patentansprüche 1 oder 2, **dadurch gekennzeichnet,**
**daß** der Temperaturfühler (1) in einem in den Laserchip (4) angebrachten, insbesondere mittels Lichtschweißens eingebrannten Loch angeordnet und befestigt ist.

4. Halbleiterlaser nach einem der Patentansprüche 1 bis 3, **dadurch gekennzeichnet,**
**daß** der Laserchip (4) selbst als Temperaturfühler (1) ausgebildet ist, in dem zusätzliche Drähte (zum Beispiel 2 und 3) zur elektrischen Widerstandsmessung durch den Halbleiterlaserchip (4) (Bahnwiderstand 11; Fig. 5a,b) auf demselben angebracht sind.

5. Halbleiterlaser nach Patentanspruch 4, **dadurch gekennzeichnet,**
**daß** nur ein zusätzlicher Draht (3) auf dem Halbleiterlaserchip (4) angebracht ist, der zusammen mit einem Pumpstromzuführungsdraht (8) als zweite Fühlerzuleitung zur elektrischen Widerstandsmessung dient.

6. Halbleiterlaser nach einem der Patentansprüche 1 bis 5, **dadurch gekennzeichnet,**
**daß** der/die Temperaturfühler (1) als Thermoelement ausgeführt ist/sind.

7. Halbleiterlaser nach einem der Patentansprüche 1 bis 6, **dadurch gekennzeichnet,**
**daß** der Temperaturfühler (1) als Thermoelement aus zwei Drähten ausgebildet ist, die mittels Laserlicht-Schweißens zusammengeführt und in demselben Arbeitsschritt auf dem Halbleiterlaserchip (4) befestigt werden.

8. Halbleiterlaser nach Patentanspruch 7, **dadurch gekennzeichnet,**
**daß** vor dem Zusammenführen der beiden Drähte eine Kontaktfläche aus dem Material des einen oder des anderen Drahtes auf dem Halbleiterlaser aufgebracht wird.

9. Halbleiterlaser nach dem Oberbegriff des Patentanspruchs 1, **dadurch gekennzeichnet,**
**daß** zur Messung der Betriebstemperatur eines Halbleiterlaserarrays die Temperatur der Einzellaser (5) gemessen wird und
**daß** ihre Ausgangswellenlängen über ihre Pumpströme abgeglichen werden.

10. Halbleiterlaser nach einem der Patentansprüche 1 bis 9, **dadurch gekennzeichnet,**
**daß** zur ortsselektiven Temperatureinstellung die auf dem Halbleiterlaserchip angeordneten Thermoelemente im Umkehrbetrieb als Peltierelemente mit Stromquelle betrieben werden.

11. Halbleiterlaser nach Patentanspruch 11, **dadurch gekennzeichnet,**
**daß** die Wellenlänge des Halbleiterlaserchips (4) gemessen und gegebenenfalls auch die Wellenlänge des Laserchips eingestellt wird, wobei Nachrichtenlaser einen Meßpunkt pro laseraktiver Zone und Hochleistungslaser mehrere Meßpunkte pro Laserchip entlang der laseraktiven Zone aufweisen.

12. Halbleiterlaser nach Patentanspruch 11 oder 12, **dadurch gekennzeichnet,**
**daß** die Thermoelemente und/oder Peltierelemente in Kaskade betrieben und angeordnet sind.

13. Halbleiterlaser nach einem der Patentansprüche 1 bis 12, **dadurch gekennzeichnet,**
**daß** ein oder mehrere Temperaturfühler (1) und Temperatursteller (15) mit je einem eignen Temperaturregler direkt auf dem Halbleiterlaser angeordnet sind.

## Claims

1. Solid-state laser with temperature probe disposed directly on the solid-state laser chip for measuring the operating temperature, **characterized in that**
at least one temperature probe (1) is fixed by means of welding directly on or in the solid-state laser chip (4), the energy required for welding being producible from a light source, particularly an Nd glass source or an NdYAG source or a source with similar spatial and similar spectral distribution.

2. Solid-state laser according to claim 1, **characterized in that**
the temperature probe (1) is, prior to the actual welding operation, melted into an electrically highly insulating glass.

3. Solid-state laser according to any one of claims 1 or 2, **characterized in that**
the temperature probe (1) is disposed and fixed in a hole provided in the laser chip (4), said hole being burned in, particularly by means of light welding.

4. Solid-state laser according to any one of claims 1 to 3, **characterized in that**
the laser chip (4) itself is in the form of a temperature probe (1) in which additional wires (for example 2 and 3) for electrical resistance measuring by the solid-state laser chip (4) (bulk resistor 11; Fig. 5a,b) are fixed thereon.

5. Solid-state laser according to claim 4, **characterized in that**
only one additional wire (3) is fixed on the solid-state laser chip (4), said additional wire (3) being used together with a pumping current supply wire (8) as a second probe lead for electrical resistance measuring.

6. Solid-state laser according to any one of claims 1 to 5, **characterized in that**
the temperature probe(s) (1) is (are) in the form of a thermocouple (thermocouples).

7. Solid-state laser according to any one of claims 1 to 6, **characterized in that**
the temperature probe (1) is in the form of a thermocouple consisting of two wires which are joined by means of laser light welding and are fixed in the same working step on the solid-state laser chip (4).

8. Solid-state laser according to claim 7, **characterized in that**
before the two wires are joined, a contact surface of the material of one or other of the wires is applied to the solid-state laser.

9. Solid-state laser according to the preamble of claim 1, **characterized in that**
in order to measure the operating temperature of a solid-state laser array, the temperature of the individual lasers (5) is measured and
their output wavelengths are trimmed via their pumping currents.

10. Solid-state laser according to any one of claims 1 to 9, **characterized in that**
for position-selective temperature setting, the thermocouples disposed on the solid-state laser chip are operated in reverse mode as Peltier elements with current source.

11. Solid-state laser according to claim 11, **characterized in that**
the wavelength of the solid-state laser chip (4) is measured and, if necessary, also the wavelength of the laser chip is adjusted, communications lasers having one measuring point per laser-active zone and high-power lasers having a plurality of measuring points per laser chip along the laser-active zone.

12. Solid-state laser according to claim 11 or 12, **characterized in that**
the thermocouples and/or Peltier elements are operated and disposed in cascade.

13. Solid-state laser according to any one of claims 1 to 12, **characterized in that**
one or more temperature probes (1) and temperature adjusters (15) each with their own temperature controller are disposed directly on the solid-state laser.

## Revendications

1. Laser semi-conducteur avec sonde de température placée directement sur la puce à laser semi-conducteur aux fins de mesurer la température d'exploitation, **caractérisé en ce que**
au moins une sonde de température (1) est directement fixée par soudure sur ou dans la puce à laser semi-conducteur (4), l'énergie nécessaire à la soudure pouvant être générée à partir d'une source de lumière, notamment une source verre Nd ou une source NdYAG ou une source de distribution dans l'espace et de distribution spectrale équivalentes.

2. Laser semi-conducteur selon la revendication 1, **caractérisé en ce que**
la sonde de température (1) est insérée avant la soudure proprement dite dans du verre à haut isolement électrique.

3. Laser semi-conducteur selon l'une des revendications 1 ou 2, **caractérisé en ce que**
la sonde de température (1) est placée et fixée dans une cavité ménagée, notamment par soudure optique, dans la puce laser (4).

4. Laser semi-conducteur selon l'une des revendications 1 à 3, **caractérisé en ce que**
la puce laser (4) forme elle-même une sonde de température (1), dans laquelle des fils supplémentaires (par exemple 2 et 3) sont disposés sur la puce à laser semi-conducteur (4) pour la mesure de la résistance électrique au niveau de celle-ci (résistance de volume 11 ; fig. 5a,b).

5. Laser semi-conducteur selon la revendication 4, **caractérisé en ce que**
un seul fil supplémentaire (3) est disposé sur la puce à laser semi-conducteur (4), lequel sert, conjointement avec un fil d'amenée de courant de pompage (8), de deuxième accès à la sonde aux fins de mesurer la résistance électrique.

6. Laser semi-conducteur selon l'une des revendications 1 à 5, **caractérisé en ce que**
la/les sondes(s) de température (1) est/sont conçue(s) comme élément thermique.

7. Laser semi-conducteur selon Tune des revendications 1 à 6, **caractérisé en ce que**
la sonde de température (1) est constituée de deux fils qui, en un même processus, sont soudés à la lumière laser et fixés sur la puce à laser semi-conducteur (4).

8. Laser semi-conducteur selon la revendication 7, **caractérisé en ce que**
avant la soudure des deux fils, une surface de contact constituée du matériau de chacun des deux fils est appliquée sur le laser semi-conducteur.

9. Laser semi-conducteur selon le principe général de la revendication 1, **caractérisé en ce que**
pour mesurer la température d'exploitation d'une rangée de lasers semi-conducteurs, l'on mesure la température des différents lasers (5) et
ses longueurs d'onde de sortie sont réglées par l'intermédiaire des courants de pompage.

10. Laser semi-conducteur selon l'une des revendications 1 à 9, **caractérisé en ce que**
pour le réglage sélectif de la température locale, les éléments thermiques disposés sur la puce à laser semi-conducteur sont exploités en mode réversible comme éléments Peltier avec source de courant.

11. Laser semi-conducteur selon la revendication 11, **caractérisé en ce que**
la longueur d'onde de la puce à laser semi-conducteur (4) est mesurée et, le cas échéant, la longueur d'onde de la puce laser est également réglée, étant entendu que les lasers de communication comportent un point de mesure par zone active et les lasers à haute performance plusieurs points de mesure par puce laser le long de la zone active.

12. Laser semi-conducteur selon la revendication 11 ou 12, **caractérisé en ce que**
les éléments thermiques et/ou les éléments Peltier sont exploités et disposés en cascade.

13. Laser semi-conducteur selon l'une des revendications 1 à 12, **caractérisé en ce que**
un(e) ou plusieurs sonde(s) de température (1) et enregistreur(s) de température (15) comprenant chacun(e) son propre régulateur de température sont disposés directement sur le laser semi-conducteur.
